# EUROPÄISCHE PATENTSCHRIFT

(11) **EP 0 922 303 B1**
(45) Veröffentlichungstag und Bekanntmachung des Hinweises auf die Patenterteilung: **23.02.2000**
(21) Anmeldenummer: 97941816.7
(22) Anmeldetag: 21.08.1997
(51) Int. Cl.: H01L 31/0336, H01L 31/032, H01L 31/18

(54) **CIS-BANDSOLARZELLE-VERFAHREN UND VORRICHTUNG ZU IHRER HERSTELLUNG**
PROCESS AND DEVICE FOR PRODUCING A CIS-STRIP SOLAR CELL
CELLULE SOLAIRE EN CIS SUR BANDE- PROCEDE ET DISPOSITIF POUR SA FABRICATION

(30) Priorität: 27.08.1996 DE 19634580
(43) Veröffentlichungstag der Anmeldung: 16.06.1999
(73) Patentinhaber: IST-Institut für Solartechnologien GmbH, 15236 Frankfurt an der Oder (DE)
(72) Erfinder: PENNDORF, Jürgen, D-15236 Hohenwalde (DE)
(74) Vertreter: Diener, Tilla
(86) Internationale Anmeldenummer: DE9701832
(87) Internationale Veröffentlichungsnummer: WO9809337

(56) Entgegenhaltungen:
- DE-A- 4 103 291
- US-A- 4 536 607
- LEE Y E ET AL: "PREPARATION OF HOMOGENEOUS POLYCRYSTALLINE CUINSE2 THIN FILMS BY A TWO-STEP CHEMICAL-VAPOR-TRANSPORT PROCESS" JOURNAL OF THE ELECTROCHEMICAL SOCIETY, Bd. 141, Nr. 2, 1.Februar 1994, Seiten 558-561, XP000450663
- KIM Y H ET AL: "PREPARATION OF CUINSE2 THIN FILMS USING ELECTRODEPOSITED IN/CU METALLIC LAYER" WORLD CONFERENCE ON PHOTOVOLTAIC ENERGY, WAIKOLOA, DEC. 5 - 9, 1994, Bd. VOL. 1, Nr. CONF. 1, 5.Dezember 1994, INSTITUTE OF ELECTRICAL AND ELECTRONICS ENGINEERS, Seiten 202-205, XP000681281
- CALIXTO E ET AL: "Electro/electroless deposition and characterization of Cu-In precursors for CIS (CuInSe2) films" JOURNAL OF CRYSTAL GROWTH, Bd. 169, Nr. 2, November 1996, Seite 287-292 XP004049330

## Beschreibung

Die Erfindung betrifft ein Verfahren zur Herstellung von Bandsolarzellen auf der Basis von einseitig mit CIS (Kupfer/Indium/Diselenid) und seinen Homologen beschichteten Kupferbändern und eine dafür geeignete apparative Vorrichtung.

Die Stromgewinnung auf der Basis photovoltaischer Module ist derzeit die umweltfreundlichste aber zugleich teuerste Variante der alternativen Energieerzeugung. Den Möglichkeiten einer weiteren Kostenreduzierung bei den zur Zeit üblichen Solarmodulen auf der Basis von einkristallinem und polykristallinem Silizium sind durch den notwendigen Materialeinsatz Grenzen gesetzt. Größere Kostenreduktionspotentiale besitzen die sogenannten Dünnschichtsolarzellen. Die Materialkosten spielen bei notwendigen Schichtdicken des aktiven Absorbers von maximal 2 - 4 um selbst beim Einsatz teurer Materialien wie Indium, Gallium und Selen eine untergeordnete Rolle. Bisher standen einer breiten Anwendung von Dünnschichtsolarzellen die geringen erreichbaren Modulwirkungsgrade entgegen. In den letzten Jahren wurden in dieser Hinsicht jedoch erhebliche Fortschritte erzielt, so daß insbesondere Dünnschichtsolarmodule auf der Basis von CuInSe₂ (CIS) mit erreichten Modulwirkungsgraden von ca. 10% vor der Pilotphase stehen.

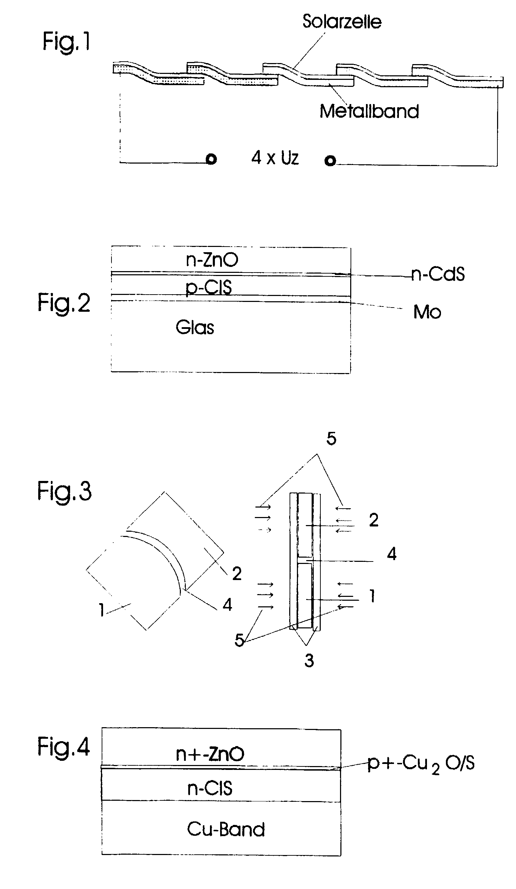

Derartige Modulwirkungsgrade setzen jedoch Zellenwirkungsgrade von 12 - 14 % voraus, die nur durch eine exakte Kontrolle der technologischen Parameter in entsprechend teuren Anlagen garantiert werden kann. Üblich sind bisher In-line-Sputter-, Bedampfungs- und Temperanlagen zur Herstellung von CIS-Modulen, wobei die hohen Abschreibungskosten derartiger Technik die Kostenreduktionspotentiale dieser Dünnschichttechnologien begrenzen. Die Geometrie der Anlagentechnik erlaubt zudem nur die Herstellung relativ schmaler Solarpaneele (meist ca. 30 cm) mit geringer Variationsbreite. Größere Anlagen, die eine effektive Produktion größerer Dünnschichtmodule erlauben würden, sind extrem teuer und erfordern Produktionsvolumina, die derzeit weltweit nicht absetzbar sind. Ein interessanter technologischer Ansatzpunkt zur Umgehung dieser Probleme ist die Beschichtung von Folien mit Solarzellen und die nachfolgende Verknüpfung von einzelnen Folienabschnitten durch eine überlappende Montage, für die eine effektive Variante in der japanischen Patent Anmeldung 2-244772 beschrieben wird. Besonders interessant ist diese Variante für den Fall, daß auf metallische Abführelektroden auf der Zelloberseite verzichtet wird. Hierbei ist, im Gegensatz zur japanischen Patent Anmeldung 2 - 244772, eine 100%-ige Ausnutzung der Modulaperturfläche gegeben ( s. Fig. 1). Die Breite der Zelle wird dann allerdings durch den Widerstand der oberen Kollektorelektrode aus einem transparenten, leitfähigen Oxid auf etwa 1cm begrenzt.

Eine ökonomische Fertigung von Solarzellen und Modulen in einer derartigen Anordnung erfordert aber enorm hohe Fertigungsgeschwindigkeiten bei der Zellherstellung, um in gleicher Zeit gegenüber der üblichen Planartechnologie vergleichbare Flächen herstellen zu können. In der Zeitschrift: Solar Energy Materials and Solar Cells, Bd 29, 1993, S. 163 - 173; DE-PS 42 25 385 sowie DE-PS 41 03 291 sind Verfahren zur Herstellung ternärer Halbleiterabsorberschichten beschrieben, bei denen CIS-Solarzellen auf flexiblen bandförmigen Substraten erzeugt werden. Dabei werden nach den bekannten Technologien Schichten aus Kupfer und Indium einzeln oder simultan aufgebracht und dann mit der dritten Komponente zur Reaktion gebracht. Ein anderes Verfahren, das auf der nachträglichen Umwandlung oxidischer Ausgangskomponenten im Schwefel- oder Selengasstrom beruht, wird in EP-A-0574 716 beschrieben. Zur Verbesserung der Funktionsparameter können die hergestellten CIS-Absorberschichten mit selektiven Ätzschritten zur Entfernung störender Kupferselenide oder -sulfide, so wie u.a. in JP-A-6-29560 beschrieben, kombiniert werden.

Keine der derzeit bekannten CIS-Technologien wird jedoch den hohen Produktivitätsanforderungen, die an die erwähnte Bandtechnologie gestellt werden, gerecht. Auch würde die Übertragung des bisher üblichen Zellaufbaus (Fig.2) den Einsatz von teuren Molybdänbändern oder mit Molybdän beschichteten Metallbändern als Substrat erfordern. Die geringe Haftfestigkeit von CIS-Schichten auf Molybdänoberflächen ist darüber hinaus ein bis jetzt nicht gelöstes Problem, das einer mit hohen mechanischen Belastungen verbundenen Bandtechnologie entgegensteht. Eine interessante Alternative wäre der Einsatz wesentlich billigerer Kupferbänder als Träger für die CIS-Solarzelle, wobei die Oberseite des Kupferbandsubstrates selbst Bestandteil der Solarzelle wird. Dieser scheitert jedoch daran, daß mit dem Kupferbandsubstrat eine praktisch unendliche Cu-Diffusionsquelle zur Verfügung steht. Mit den üblichen Technologien ist in diesem Fall eine exakte, für effektive CIS-Solarzellen aber unbedingt notwendige Steuerung der Zusammensetzung der CIS-Schichten nicht möglich.

Aufgabe der vorliegenden Erfindung ist es daher, ein Verfahren und die dafür notwendige anlagentechnische Lösung sowie den erforderlichen Schichtaufbau zu beschreiben mit der eine hocheffiziente und ökonomische Abscheidung haftfester CIS-Solarzellen auf Kupferbändern möglich ist.

Erfindungsgemäß wird diese Aufgabe dadurch gelöst, daß in einem ersten Schritt ein vorgereinigte Kupferband kontinuierlich (Spule zu Spule) einseitig galvanisch mit Indium, Gallium oder In/Ga-Legierungen beschichtet, in einem zweiten Schritt das mit Indium, Gallium oder In/Ga-Legierungen beschichtete Kupferband im Kontaktverfahren mit einem beheizten Graphitkörper kontinuierlich sehr schnell aufgeheizt und einseitig in einem schmalen Spalt mit erhitztem schwefel-oder selenhaltigen Trägergas in Kontakt gebracht, in einem dritten Schritt selektiv die wachstumsbedingt entstandene Deckschicht aus Kupfersulfid oder -selenid ätztechnisch entfernt und in einem vierten Schritt die Oberfläche der CIS-Schicht mit einer p⁺-leitenden transparenten Kollektor- und Anpaßschicht aus Kupferoxid/sulfid, versehen wird. Die galvanische Abscheidung von Indium auf Kupfer ist ein äußerst ökonomischer und schneller Prozeß, der technisch beherrscht wird und eine reproduzierbare und genaue Einstellung der Indiumschichtdicke bei sparsamsten Materialeinsatz gestattet. Die entsprechenden Bäder sind kommerziell erhältlich. Die einseitige kontinuierliche Beschichtung wird dabei so realisiert, daß das Kupferband im galvanischen Bad über ein teilweise eintauchendes Führungsrad läuft. Zweckmäßigerweise kann die kathodische Abscheidung von Indium mit einer vorgelagerten anodischen Reinigung der Kupferoberfläche in verdünnter Phosphorsäure kombiniert werden. Zur Sulfidisierung wird das mit Indium beschichtete Kupferband durch Ziehen über einen strahlungsbeheizten, an der Oberfläche gewölbten Graphitblock innerhalb weniger Sekunden auf Temperaturen von 550 - 650 °C aufgeheizt und mit schwefeldampf- oder selendampfgesättigtem Stickstoffträgergas in Kontakt gebracht. Den prinzipiellen Aufbau des dazu zweckmäßigerweise angewendeten Reaktors zeigt Fig.3. Der Reaktor besteht aus dem an der Spaltoberfläche konvex gewölbten Bandheizer I aus Graphit, dem an der Spaltoberfläche konkav gewölbten Gasheizer 2 ebenfalls aus Graphit und den Quarzglasplatten 3, die den zwischen Bandheizer und Gasheizer eingestellten Spalt 4 nach außen abdichten. Bandheizer und Gasheizer können über thermisch schnelle Strahlungsheizer 5 von innen oder von außen separat auf die notwendigen Prozeßtemperaturen aufgeheizt werden.

Die Vorteile dieser apparativen Anordnung sind:
- Sicherung des schnellen und kontinuierlichen Temperatureintrages in das Band ohne rotierende geheizte Teile durch Ausnutzung der guten Gleiteigenschaften und Wärmeleitfähigkeit des Graphits;
- hohe Effizienz bei der Materialausnutzung durch den eng begrenzten, genau definierten Reaktionsraum;
- Sicherung einer hohen Reaktivität von Selen und Schwefel durch Temperaturen im Gasheizer, die über den Bandtemperaturen liegen;
- einfacher und billiger Aufbau.

Die sehr schnelle Aufheizung des Bandes bildet die physikalisch - chemische Grundlage für die beschriebene CIS-Bandtechnologie. Unter Ausnutzung der unterschiedlichen Diffusionsgeschwindigkeiten von In bzw. Cu in der festen (Cu-Band) und flüssigen (In-Schmelze) Phase wird durch ein sehr schnelles Aufheizen erreicht, daß die In-Schmelze entsprechend der im Phasendiagramm Cu - In erreichten Liquidustemperatur von vorzugsweise 550 - 650°C sehr schnell mit Cu gesättigt wird, während die Eindiffusion des In in das Kupferband eine untergeordnete Rolle spielt. Wird die heiße, mit Cu gesättigte In-Schmelze, wie oben beschrieben, mit hochreaktiven S oder Se in Kontakt gebracht, erfolgt die Umsetzung zu CIS praktisch schlagartig. Die Prozeßzeiten können daher im Gegensatz zu den bisher üblichen Technologien, bei denen die CIS-Bildung stets über die viel langsameren Festkörperreaktionen abläuft, wesentlich verkürzt werden. Damit werden sehr hohe Bandvortriebsgeschwindigkeiten möglich, die eine wesentliche Voraussetzung für die Ökonomie der Bandtechnologie bilden. Die sehr kurzen Prozeßzeiten im Sekundenbereich bei der Sulfidisierung bzw. Selenisierung sind allerdings auch eine unbedingte Notwendigkeit, da durch die praktisch unbegrenzte Cu-Quelle des Kupferbandsubstrates bei den entsprechenden Prozeßtemperaturen von über 550 °C eine ständige Nachdiffusion von Cu erfolgt. Die Anwesenheit von reaktiven Komponenten wie S und Se an der Bandoberfläche führt dann zur Bildung von Deckschichten aus Kupfersulfid bzw. Kupferselenid, die bei zu langen Prozeßzeiten die anfangs gebildete, geschlossene CIS-Schicht zerstören. Diese im Prozeß immer entstehenden mehr oder weniger dicken Deckschichten aus Kupfersulfid oder -selenid müssen dem Stand der Technik entsprechend durch eine Zyanidätzung nachfolgend selektiv entfernt werden. Die nach der Ätzung an der Bandoberfläche freigelegte CIS-Schicht ist frei von störenden Fremdphasen und weist die für effektive Absorberschichten notwendigen Parameter wie Schichtdicken im Bereich von 1 - 2 µm, Columnarstruktur sowie gute optische und elektrische Eigenschaften auf. Sie ist fest mit dem Bandsubstrat verwachsen und hat die für die Bandtechnologie notwendige mechanische Stabilität. Die mit der beschriebenen Technologie hergestellten CIS-Schichten sind allerdings mehr oder weniger stark n-leitend und erfordern daher einen gegenüber dem Stand der Technik (Fig.2) grundsätzlich anderen Deckschichtaufbau. Zur Realisierung des für die Solarzelle notwendigen p/n-Überganges muß der n-Absorber mit einer transparenten p⁺-Anpaßbzw. Kollektorschicht versehen werden. Dem Stand der Technik entsprechend ist dafür im wesentlichen nur ZnTe geeignet, das die entsprechenden optischen und elektrischen Eigenschaften aufweist. Eigene Experimente mit ZnTe-Deckschichten auf den nach der beschriebenen Technologie hergestellten CIS-beschichteten Kupferbändern belegen die prinzipielle Möglichkeit der Herstellung von Solarzellen. Die derzeit bekannten technischen Möglichkeiten der Einpassung einer ZnTe-Abscheidung in den Bandprozeß sind jedoch begrenzt, so daß als bessere Alternative erfindungsgemäß eine hocheffiziente und sehr schnelle Sol-Gel-Technik zur Herstellung hochleitfähiger, transparenter p⁺ -Schichten aus Kupferoxid/sulfid entwickelt wurde. Die entsprechende Stammlösung wird auf der Basis von alkoholischen oder wässrigen Lösungen von Kupferacetat und Thioharnstoff hergestellt. Diese Lösung wird über ein einfaches Tauchverfahren kontinuierlich auf die zyanidgeätzte CIS-Oberfläche aufgebracht und bei Temperaturen von ca. 250 - 450°C im Kontaktverfahren sekundenschnell ausgetempert. Derartig hergestellte CIS-Solarzellen auf Sulfidbasis zeigen die für hocheffiziente Solarzellen notwendigen Leerlaufspannungen und Kurzschlußströme. Da die Cu₂O/S - Deckschicht mit ihrer Absorptionskante die Effektivität der CIS-Solarzellen beschneidet, ist die Anwendung dieser Schicht als dünne Anpaßschicht in Kombination mit einer üblichen ZnO-Kollektorschicht sinnvoll. Zwischen der p⁺- Cu₂O/S - Anpaßschicht und n⁺ - ZnO-Kollektorschicht entsteht elektronisch gesehen eine Tunneldiode, die, analog den Erfahrungen bei der Herstellung von pin-Strukturen auf der Basis von amorphen Silizium, die Eigenschaften der Solarzelle nur unwesentlich beeinflußt. Der prinzipielle Schichtaufbau der nach der beschriebenen Technologie hergestellten CIS-Solarzelle wird in Fig.4 gezeigt. Die Erfindung soll nachfolgend anhand eines Ausführungsbeispieles näher erläutert werden. In den zugehörigen Zeichnungen zeigen:
- Fig.1 -: Das vorteilhafte Modulverschaltungskonzept für Bandsolarzellen;
- Fig.2 -: Den Stand der Technik bezüglich des Aufbaus von CIS-Solarzellen;
- Fig.3 -: Den prinzipiellen Aufbau des Schmalspaltreaktors zur Herstellung von CIS-Bandsolarzellen auf Basis der vorliegenden Erfindung;
( 1 = Bandheizer aus Graphit, 2 = Gasheizer aus Graphit; 3 = Quarzglasplatten, 4 = Reaktionsspalt, 5 = Strahlungsheizer)
- Fig.4 -: Den Aufbau CIS-Bandsolarzelle gemäß vorliegender Erfindung.

Ausgangsmaterial ist ein auf eine Spule gewickeltes 1 cm breites und 0,1mm dickes kommerziell erhältliches Kupferband. Zur Reinigung wird dieses Band in einer kombinierten Bandanlage anodisch in 50°C heißer 50%iger Phosphorsäure geätzt und anschließend sofort kathodisch einseitig mit einer 1 um dicken In-Schicht versehen.

Als galvanisches Bad wird schwefelsaurer wässriger In-Elektrolyt eingesetzt.

Anschließend wird das beschichtete Band im strahlungsbeheizten Spaltreaktor auf 580°C aufgeheizt und im schwefeldampfgesättigtem Stickstoffträgergasstrom sulfidisiert. Die Temperatur des Gasheizers beträgt dabei 700°C und die Bandvortriebsgeschwindigkeit 10 cm / sec. Die Sättigung des Trägergases mit Schwefeldampf erfolgt in einer strahlungsbeheizten Schwefelquelle bei 350°C. Der Reaktionsspalt ist 1mm hoch, 12mm breit und 30 cm lang.

Das selektive Abätzen der Cu2S-Deckschicht erfolgt anschließend kontinuierlich in einer Bandätzanlage mit einer 80°C heißen 10%-igen KCN-Lösung.

Abschließend wird die CIS-Schicht mit einer Anpaß- und Kollektorschicht aus Cu₂O/S versehen, indem in einer Bandanlage das CIS-beschichtete Kupferband oberflächlich mit einer Sol-Lösung aus Methanol/Thioharnstoff/Kupferacetat tauchbeschichtet und nachträglich sofort durch Ziehen über einen 300°C heißen Graphitblock ausgetempert wird.

## Patentansprüche

1. Verfahren zur Herstellung von CIS-Bandsolarzellen gekennzeichnet dadurch, daß in einem ersten Schritt ein vorgereinigtes Kupferband kontinuierlich von Spule zu Spule einseitig galvanisch mit Indium, Gallium oder In/Ga-Legierungen beschichtet, in einem zweiten Schritt das mit Indium, Gallium oder In/Ga-Legierungen beschichtete Kupferband im Kontaktverfahren mit einem beheizten Graphitkörper kontinuierlich auf 550 - 650° C geheizt und einseitig in einem schmalen Spalt mit erhitztem schwefel-oder selenhaltigen Trägergas in Kontakt gebracht, in einem dritten Schritt selektiv eine entstandene Deckschicht aus Kupfersulfid oder -selenid ätztechnisch entfernt und in einem vierten Schritt die Oberfläche der CIS-Schicht mittels einer Sol - Gel - Technik mit einer p⁺-leitenden transparenten Kollektor- und Anpaßschicht aus Kupfer-I-Oxid, Kupfersulfid, Mischungen aus Kupfer-I-Oxid und Kupfersulfiden oder Zinktellurid versehen wird.

2. Verfahren nach Anspruch 1 zur Herstellung einer p⁺- leitenden, transparenten Kollektor- und Anpaßschicht aus Kupferoxid/sulfid, gekennzeichnet dadurch, daß eine Stammlösung auf der Basis von alkoholischen oder wassrigen Lösungen von Kupferacetat und Thioharnstoff hergestellt, die Lösung kontinuierlich auf die zyanidgeätzte CIS- Oberfläche aufgebracht und bei Temperaturen von 250 - 450° C im Kontaktverfahren ausgetempert wird.

3. Schmalspaltreaktor zur Durchführung des Verfahrens nach Anspruch 1 gekennzeichnet dadurch, daß ein Reaktionsspalt (4) durch einen strahlungsbeheizten, an der Spaltoberfläche konvex gewölbten feststehenden Bandheizer (1) aus Graphit und einen strahlungsbeheizten, an der Spaltoberfläche konkav gewölbten Gasheizer (2), ebenfalls aus Graphit ausgebildet ist und der Reaktionsspalt (4) nach außen mittels zweier Quarzglasplatten (3) abgedichtet ist.

## Claims

1. A process for producing CIS-strip solar cells, characterised in that a copper band cleaned in a preliminary way is continuously coated with indium, gallium and/or In/Ga-alloys galvanically on one side from coil to coil in a first step, the copper band coated with indium, gallium or In/Ga-alloys is continuously heated to 550 - 650°C in a contact process with a heated graphite body and brought into contact on one side in a small gap with a heated carrier gas containing sulphur or selenium in the second step, a resulting surface layer consisting of copper sulfide or selenide is selectively removed by means of an etching process in a third step and the surface of the CIS-layer is provided with a p⁺ -conducting, transparent collector and buffer layer consisting of copper-I-oxide, copper sulfide, mixtures of copper-I-oxide and copper sulfides or zinc telluride by means of a sol-gel-method in the fourth step.

2. A process as claimed in Claim 1 for producing a p⁺-conducting, transparent collector and matching layer consisting of copper oxide/sulfide characterised in that a stock solution is produced on the basis of alcoholic or aqueous solutions of copper acetate and thiourea, the solution is continuously applied to the cyanide-etched CIS-surface and annealed at temperatures from 250 to 450°C in the contact process.

3. Narrow-gap reactor for carrying out the process as claimed in Claim 1 characterised in that a reaction gap (4) is formed by a radiation-heated, stationary strip heater (1) rounded convexly at the gap surface, the heater consisting of graphite, and a gas heater (2) rounded concavely at the gap surface, also made from graphite and the reaction gap (4) sealed externally by means of two quartz glass plates (3).

## Revendications

1. Procédé de fabrication de cellules solaires en CIS sur bande, caractérisé en ceci
que, dans un premier pas, une bande de cuivre nettoyée préalablement est induite de manière continue de bobine à bobine sur une face à l'indium, au gallium ou un alliage in/ga, que dans un second pas, la bande de cuivre enduite d'indium, de gallium ou d'un alliage in/ga est chauffée en continu à 550 - 650 °C avec un corps chauffant au graphite par contact et, le long d'une fente étroite unilatérale, est mise en contact de façon continue avec un gaz porteur chauffé contenant du soufre ou du sélénium, que dans un troisième pas la couche de recouvrement de sulfure de cuivre ou de sulfure de sélénium ainsi obtenue est décapée sélectivement en technique de gravure et que dans un quatrième pas, la surface de la couche CIS est dotée en technique sol - gel d'une couche collectrice et d'adaptation transparente et conductrice p⁺ d'I-oxyde de cuivre, sulfure de cuivre, mélange de I-oxyde de cuivre et de sulfures de cuivre ou tellurure de zinc.

2. Procédé selon la revendication 1 pour la fabrication d'une couche collectrice et d'adaptation transparente, conductrice p⁺, caractérisé en ceci qu'une solution-mère est confectionnée à partir de solutions alcooliques ou aqueuses d'acétate de cuivre et de thiourée, que la solution est appliquée en continu sur la surface CIS attaquée au cyanure et amenée à une température de 250 à 450 °C par contact.

3. Réacteur à fente étroite pour la réalisation du procédé selon la revendication 1, caractérisé en ceci qu'une fente de réaction (4) est formée par un chauffage de bande (1) en graphite, dont la face de fission est convexe, fixé sur la surface de la fente, et par un chauffage de gaz (2) également en graphite, chauffé par rayonnement, dont la face de fission est concave, et que la fente de réaction (4) est étanchéifiée extérieurement par deux plaques de verre de quartz (3).
